(19) Europäisches Patentamt
European Patent Office
Office européen des brevets

(11)     **EP 1 570 282 B1**

(12)     **EUROPEAN PATENT SPECIFICATION**

(45) Date of publication and mention
of the grant of the patent:
**18.06.2008  Bulletin 2008/25**

(51) Int Cl.:
**G01R 33/20** [(2006.01)]

(21) Application number: **03779582.0**

(22) Date of filing: **28.11.2003**

(86) International application number:
**PCT/BG2003/000042**

(87) International publication number:
**WO 2004/051299 (17.06.2004 Gazette 2004/25)**

(54) **METHOD AND DEVICE FOR MEASUREMENT OF MAGNETIC INDUCTION**

VERFAHREN UND GERÄT ZUR MESSUNG DER MAGNETISCHEN INDUKTION

PROCEDE ET DISPOSITIF POUR MESURER UNE INDUCTION MAGNETIQUE

(84) Designated Contracting States:
**AT BE BG CH CY CZ DE DK EE ES FI FR GB GR HU IE IT LI LU MC NL PT RO SE SI SK TR**

(30) Priority: **03.12.2002  BG 10735002**

(43) Date of publication of application:
**07.09.2005  Bulletin 2005/36**

(73) Proprietors:
• **University of Siena Department of Physics**
  **I-53100 Siena (IT)**
• **Institute of Experimental Physics Technical University of Graz**
  **A-8010 Graz (AT)**
• **Institute of Electronics Bulgarian Academy of Sciences**
  **1784 Sofia (BG)**
• **Optella Ltd.**
  **1113 Sofia (BG)**
• **Optela-Optical Technologies JSCO**
  **4023 Plovdiv (BG)**

(72) Inventors:
• **BIANCALANA, V.,**
  **Universita degli Studi di Siena**
  **I-53100 Siena (IT)**
• **DANCHEVA, Yordanka**
  **Universita degli Studi di Siena**
  **I-53100 Siena (IT)**
• **MARIOTTI, Emilio**
  **Universita degli Studi di Siena**
  **I-53100 Siena (IT)**
• **MOI, Luigi**
  **Universita degli Studi di Siena**
  **I-53100 Siena (IT)**
• **CARTALEVA, Steffka,**
  **Bulgarian Academy of Sciences**
  **1784 Sofia (BG)**
• **ANDREEVA, Christina,**
  **Bulgarian Academy of Sciences**
  **1784 Sofia (BG)**

(74) Representative: **Andreeva, Natasha Petkova**
**Borislav Boyanov & Co,**
**24, Patriarch Evtimii Boulevard**
**1000 Sofia (BG)**

(56) References cited:
• **WYNANDS R ET AL: "Miniaturized laser magnetometers and clocks" PROCEEDINGS OF QUANTUM AND ATOMIC OPTICS ..., July 2001 (2001-07), pages 126-137, XP001193809 ISSN: 0277-786X**
• **STAHLER M ET AL: "Picotesla magnetometry with coherent dark states" EUROPHYS. LETT., vol. 54, May 2001 (2001-05), pages 323-328, XP008031415 ISSN: 0295-5075 cited in the application**
• **KITCHING J ET AL: "A microwave frequency reference based on VCSEL-driven dark line resonances in Cs vapor" IEEE TRANS. INSTRUM. MEAS., vol. 49, 2000, pages 1313-1317, XP002283619 ISSN: 0018-9456**
• **VAN WIJNGAARDEN W A ET AL: "Magnetic-field decoupling of an alkali-metal excited-state hyperfine structure" PHYS. REV. A, vol. 43, 1991, pages 2171-2178, XP002283620 ISSN: 1050-2947**

**EP 1 570 282 B1**

**Description**

Field of the Invention

The present invention relates to an all-optical method and device for measurement of magnetic induction of small magnetic fields and small changes in magnetic fields based on Coherent Resonances (CR). In the present description, the term "small magnetic fields" refers to magnetic fields whose induction is within the interval from ~ 100 pT to ~ 1 mT, and the term "big magnetic fields" - to magnetic fields whose induction is higher than ~ 1 mT. Also, a "small change of the magnetic field" refers to a change in the magnetic induction within the interval from ~ 100 pT, to ~ 1 mT.

In particular, the invention refers to a method and device for measurement of magnetic induction by using CR at a single hyperfine transition in atoms of alkali metals, where the atomic system is coherently excited by means of a laser source with a modulation of the optic frequency with a frequency lower than 1 GHz and where the modulation frequency at which the CR are registered is used as a measure of the induction of the existing magnetic field.

Background of the Invention

A method is known for measurement of the magnetic induction of constant magnetic fields, based on the so called effect of Coherent Population Trapping (CPT). It consists in the following:

Two coherent electromagnetic fields excite two transitions of alkali atoms starting from two basic-state hyperfine levels with different energies to a common excited-state level. The frequency of one of the transitions is denoted by $\omega_1$, and of the other - $\omega_2$, where for example $\omega_1 > \omega_2$. Two coherent electromagnetic fields with frequencies $\omega_{L1}$ and $\omega_{L2}$ irradiate the absorbing atomic medium. The frequency of one of the electromagnetic fields is $\omega_{L1} \approx \omega_1$, while the frequency of the other field $\omega_{L2}$ is adjusted in a small interval around $\omega_2$. The fluorescence signal from the excited state relaxation or the transmitted through the absorbing medium laser power is registered in dependence on the detuning of $\omega_{L2}$ around $\omega_2$. Thus, in the fluorescence signal or the transmitted laser power a narrow dip or peak is registered due to CPT. This dip or peak has the characteristics that its extremum is obtained when the difference in the frequency of the scanned and the fixed electromagnetic fields is equal to the difference in the frequencies of the two basic-state levels, i.e. when $\omega_1 - \omega_2 = \omega_{L1} - \omega_{L2}$, thus satisfying the two-photon Raman resonance condition.

In the presence of magnetic field, the atomic hyperfine energy levels are split due to Zeeman effect, where the number of the sublevels is determined by the total angular momentum of the respective hyperfine level $F$ and is equal to $2F + 1$. A characteristics of these sublevels is their magnetic quantum number $m_F$, where $m_F = - F, - F + 1, ... , F -1, F$.

At resonance excitation, depending on the ratio between the total angular momenta of the basic state $F_g$ and the excited state $F_e$, three kinds of transitions are possible:

- transitions with $F_g = F_e + 1$, further called I type,
- transitions with $F_g = F_e$, further called II type,
- transitions with $F_g = F_e - 1$, further called III type.

Thus, the bi-frequency excitation with $\omega_{L1}$ and $\omega_{L2}$ leads to CPT observation at the split Zeeman sublevels of the two basic-state hyperfine levels. Again, when scanning the frequency of one of the electromagnetic fields, for example $\omega_{L2}$, around the two-photon Raman resonance condition frequency, in the fluorescence or absorption signal of the excited state several CPT resonances are observed. The number of these resonances depends on the total angular momenta of the levels involved in the process. The Zeeman splitting of the hyperfine levels depends on the magnetic field strength, where the energy of the magnetic sublevels is given by the Breit-Rabi formula:

$$\mathrm{E}_{|J=1/2,I,m_F\rangle} = \frac{\Delta E_{hfs}}{2(2I+1)} + g_I \mu_B m_F B \pm \frac{\Delta E_{hfs}}{2}\left(1 + \frac{4m_F x}{2I+1} + x^2\right)^{1/2},$$

where:

$\Delta E_{hfs}$ is the hyperfine splitting of the basic state,
I - the spin angular momentum of the nucleus,
J - the total electron angular momentum,
$\mu_B$ is the Bohr magneton,
$g_I$ - the Lande factor of the nucleus,

$g_J$ - the Lande factor of the electron,
$B$ - the magnetic field induction

and the symbol x denotes:

$$x = \frac{(g_J - g_I)\mu_B B}{\Delta E_{hfs}}.$$

At relatively small magnetic fields the Zeeman sublevels splitting $\Delta$ is (in the linear approximation):

$$\Delta = \mu_B \ g_F \ m_F \ B,$$

where $g_F$ is the Lande factor of the level, given by:

$$g_F = g_J \frac{F(F+1)-I(I+1)+J(J+1)}{2F(F+1)} + g_I \frac{F(F+1)+I(I+1)-J(J+1)}{2F(F+1)} \approx g_J \frac{F(F+1)-I(I+1)+J(J+1)}{2F(F+1)}$$

Therefore, the frequency difference between the registered CPT resonances in presence of magnetic field is proportional to the magnetic induction $B$.

In order to measure the distance between the CPT resonances, it is necessary to measure precisely the difference in the frequencies of the two electromagnetic fields ($\omega_{L1}$ - $\omega_{L2}$) at which the extrema of the resonances in the fluorescence or the transmitted laser power are observed during the scan of the frequency $\omega_{L2}$ around the two-photon Raman resonance condition frequency.

It is important to note that in the case of alkali atoms for which CPT has been observed ($\omega_1$ - $\omega_2$) is in the GHz range.

A major advantage of this method of magnetic induction measurement is that it is an all-optical detection. This makes possible the measurement of the induction of magnetic fields at a distance from the registration equipment (by means of optical fibers), thus strongly reducing the influence of the magnetic and electromagnetic fields induced by the measuring apparatus on the measured magnetic field. Besides, the optical method allows the realization of measurements with spatial resolution much higher than that of other existing methods of absolute measurement.

As a most compact and easy-to-use laser source, most frequently the semiconductor lasers (diode lasers) are used. These lasers are suitable for excitation of different transitions in Rb and Cs. Their small size makes them attractive for the solution of practical problems.

The application of this method requires the creation of the two coherent electromagnetic fields with frequencies $\omega_{L1}$ and $\omega_{L2}$.

One possibility for producing the two coherent fields is to use an electro-optical modulator (EOM). This is a special nonlinear crystal, optically transparent in a certain spectral interval. The application of radio-frequency (rf) power leads to phase modulation of the light transmitted through the crystal electromagnetic field. As a result of this phase modulation, in the output spectrum of the emission sidebands appear, whose frequency separation from the carrier frequency is equal to an integer multiple of the frequency of the rf field applied to the crystal. As mentioned earlier, two coherent electromagnetic fields are required for synchronous excitation of the two basic-state hyperfine levels. In principle, all atoms of alkali metals can be used as an atomic medium in the described method. For all alkali atoms for which CPT has been observed, the frequency separation between the basic-state hyperfine levels is larger than 1 GHz, and in the case of Cs it reaches 9.2 GHz. In order to create two coherent fields with a frequency difference above 1 GHz by using EOM, significant rf power is required - of the order of 1 Watt. The application of such high power to the EOM leads to uncontrollable heating of the crystal and thus - to uncontrollable change in the modulation index. The change in the modulation index means a change in the intensities of the CPT-preparing electromagnetic fields produced, and thus - to increased noise in the signal and to uncontrolled light shift of the transition. This brings significant errors in the determination of the value of the magnetic field induction due to the shift of the centers of the CPT resonances.

Another experimental approach for precise magnetic field induction measurement based on CPT is known, where the two necessary coherent electromagnetic Betas are produced by two different laser sources. In this case, though, it is necessary to create a constant phase difference between the two laser fields (thus ensuring their coherence) in order to observe CPT resonances. This constant phase difference is provided by sophisticated electronic circuit including a stable 20 MHz oscillator, phase detector and feedback loop for keeping constant phase difference between the two laser fields.

For measurement of magnetic field induction, also a GHzz generator is required, as well as a mixer, on which the beat signal between the two lasers is fed after appropriate amplification, for measurement of the frequency difference of the two lasers.

Another approach is the use of direct modulation of the injection current of the diode laser with the required modulation frequency, as described by M. Stähler, S. Knappe, C. Affolderbach, W. Kemp, R. Wynands, "Picotesla magnetometry with coherent dark states", Europhysics Letters 54 (3), 323-328 (2001) and later reported in Wynands, Affolderbach, Hollberg, Kitching, Knappe, Stahler, "Miniaturized laser magnetometers and clocks", ICONO 2001: Quantum and Atomic Optics, HighPrecision Measurements in Optics, and Optical Information Processing Proc. SPIE v. 4750 (2002), p. 126. Thus again in the laser spectrum sidebands appear, separated from the laser carder frequency by an integer multiple of the modulation frequency. In this case, for CPT preparation both the carrier frequency and one sideband, as well as two sidebands can be used. Direct modulation of the diode laser current in the GHz range, though, is not that effective. In this frequency interval small modulation indices can be reached, as the relaxation frequencies of the semiconductor are exactly in the $1 \div 3$ GHz range.

It is possible to perform modulation at smaller frequencies and use of sidebands at higher order. In this case the modulation index is higher, but the laser spectrum contains many additional frequency components, leading to unwanted light shift, as well as single-photon transitions. These two effects lead to inaccuracies in the determination of the magnetic field induction,

For the realization of all of the above described methods, the utilization of a high-precision GHz generator with high output rf power is required for generating the two coherent electromagnetic fields for CPT preparation, which makes the method more expensive and difficult for practical applications.

### Summary of the Invention

Therefore, it is an object of the present invention to provide a method and device for measurement of the magnetic induction of small magnetic fields of the order of ~ 100pT to ~ 1 mT or of small changes of the same order in magnetic fields, by means of simultaneous coherent excitation of two Zeeman sublevels of a single basic-state hyperfine level to a common excited one, where for CR registration, a modulation of the laser frequency at modulation frequencies much smaller than 1 GHz, namely less than several MHz is applied. Thus higher accuracy and lower noise measurements are achieved.

It is another object of the present invention to provide a method and device for measurement of the magnetic induction of small magnetic fields - of the order of ~ 100 PT to ~ 1 mT or of small changes of the same order in magnetic fields, by using CR at Zeeman sublevels of a single hyperfine transition, where the CR are obtained by modulation of the oscillation frequency of the laser at modulation frequencies up to several MHz, and where the hyperfine transition is such that the degeneracy of the basic-state hyperfine level is smaller than the degeneracy of the excited hyperfine level.

It is a further object of the present invention to provide a method and device for measurement of the magnetic induction of small magnetic fields - of the order of ~ 100 pT to ~ 1 mT or of small changes of the same order in magnetic fields, by using CR at the Zeeman sublevels of a single hyperfine transition, where the CR are obtained by modulation of the oscillation frequency of the laser at modulation frequencies up to several MHz, where not only the magnitude, but also the direction of the magnetic induction are determined.

The proposed method for measurement of the magnetic induction of small magnetic fields or of small changes in the magnetic field consists in the following steps:

(1) Creating a frequency modulated laser field with a carrier frequency $\omega_0$ and modulation frequency $\Omega_M$, so that the spectrum of the laser comprises a carrier frequency $\omega_0$ and sidebands with frequencies $\omega_0 \pm n \, \Omega_M$, where:

- n is an integer
- $\Omega_M$ is modulation frequency in the kHz or MHz range and can be adjusted;

(2) Putting of an alkali atoms sample under the influence of the measured magnetic field, removing the Zeeman degeneracy of the atomic levels;

(3) Choosing appropriate polarization of the laser light, preferably linear, and irradiation of a certain hyperfine transition of the atomic medium, which can be of the I, II or III type;

(4) Registration of the fluorescence signal of the atomic sample in a direction perpendicular to the laser beam propagation direction, or of the power transmitted through the sample laser;

(5) Smooth adjustment of the modulation frequency $\Omega_M$ from a minimal value to registration of a full set of resonances for the respective modulation index or determination of the ratio between the frequencies at which two arbitrary adjacent resonances are registered for determining a proportionality coefficient between the modulation frequency at which one of these two resonances is registered, and the value of the Zeeman splitting using the Breit-Rabi formula;

(6) Calculation of the magnetic induction of the magnetic field from the value of the modulation frequency $\Omega_M$ at which the last resonance from the set is registered, i.e. the maximal $\Omega_M$ value at which a resonance is registered, or from the proportionality coefficient obtained for one of the two adjacent resonances and the respective modulation frequency at which it is registered.

The method for measurement of small changes in the magnetic induction of magnetic fields is similar to the described method for measurement of the magnetic induction of small magnetic fields, where instead of step (2), the following step is performed:

(2a) Putting of the sample of alkali atoms in a system for magnetic field compensation for compensation of the big external magnetic field.

The procedure of steps (1), (2a), and (3) to (6) allows the measurement of the changes in the initially compensated magnetic field in the cases when this change is within the range ~ 100 pT to ~ 1 mT.

The method for measurement of the direction of the magnetic induction of small magnetic fields or of small changes in the magnetic field includes the following additional steps:

(7) Application of calibrated magnetic field in the two directions of three mutually perpendicular axes and repeating of steps (1) to (6) for each measurement.

(8) From the difference in the values of the measured magnetic field obtained with application of the calibrated magnetic field in the two directions of each axis, determination of the projection of the unknown magnetic field on the respective axis, thus giving the direction of the magnetic induction of the unknown small magnetic transmitted through the sample laser power, the system being connected to a module for data processing and visualization.

The device can also include a system for shielding or compensation of stray magnetic fields, as well as for application of calibrated magnetic field in each direction of the three mutually perpendicular axes for determination of the direction of the measured magnetic field.

In one embodiment of the device, the system for adjustable frequency modulation is preferably a system for direct diode laser current modulation.

- In the preferred embodiment the alkali atoms sample is a sealed cell with alkali metal - evacuated or with buffer gas added.

The described method for magnetic induction measurement and the device operating on its principle have all above described advantages as:

- High spatial resolution, which can reach micrometric dimensions, due to the fact that electromagnetic fields with frequencies in the optical range are used whose parameters can be precisely controlled;

- The using of the laser frequency modulation provides the preparation of electromagnetic fields with different frequencies, which are completely spatially overlapped, and therefore there is no risk of broadening of the CR and thus decreasing the relative accuracy of measurement;

- As an all-optical method, it makes possible to perform measurements at a distance from the measuring equipment, eliminating the influence of the created by it magnetic field on the measured one;

- For the use of CR at the Zeeman sublevels of a single hyperfine level as a measure for the value of the magnetic field a generator providing up to several MHz is required, since for measurement of magnetic fields of around 1 mT, the frequency difference between the two laser fields should be of the same order.

- The application of small-frequency modulation to the diode laser current eliminates the necessity of high rf power, as in this modulation frequency interval high modulation indices are reached at much smaller rf powers;

- It is possible to determine the direction of the measured magnetic field with smaller absolute accuracy than its absolute value by applying calibrated magnetic field.

Brief Description of the Drawings

The further objects and advantages of the invention can be better understood from the following detailed description with reference to the accompanying drawings, where:

Figure 1 represents the excitation scheme for type I transitions.

Figure 2 shows the excitation scheme for type II transitions.

Figure 3 shows the excitation scheme for type III transitions, where the inset illustrates the propagation direction of the laser beam, its polarization vector and the magnetic field, as well as two electromagnetic fields with frequencies $\omega_{L1}$ and $\omega_{L2}$ with $\sigma^+$ and $\sigma^-$ polarization, respectively.

Figure 4 shows the excitation scheme for type I transition, where the inset illustrates the propagation direction of the laser beam (k) along the z axis, the direction of the electric vector (E) of the linearly polarized laser light along the y axis, and arbitrary oriented magnetic field (B) with the respective components along the three mutually perpendicular axes (x, y, z). Two electromagnetic fields with frequencies $\omega_{L1}$ and $\omega_{L2}$ are also shown, having $\sigma^+$ and $\sigma^-$ or $\pi$-polarizations, respectively.

In Figure 5 a vector diagram is shown of the direction and magnitude of the resulting magnetic induction when applying calibrated magnetic field in a certain direction.

The light of a diode laser with oscillation frequency $\omega_0$ is modulated preferably by direct diode laser injection current modulation, whose modulation frequency $\Omega_M$ is up to several MHz. Thus, besides the carrier frequency $\omega_0$, sidebands appear in the laser spectrum, with frequencies $\omega_n^{\pm} = \omega_0 \pm n\Omega_M$, where n is an integer from 1 to $\infty$.

It should be noted that for modulation at frequencies up to several MHz, no big rf power is required for obtaining high enough modulation index with respect to the GHz frequency modulation. It is preferable to operate at low rf power, where for the required modulation frequency interval several sidebands appear. Preferably, the modulation frequency of the diode laser injection current is continuously adjusted in a broad spectral interval.

The sample of alkali atoms is put under the influence of the measured magnetic field. It removes the Zeeman degeneracy of the atomic levels. A certain transition is chosen - of the I, II or III type.

According to one preferred embodiment of the invention, a I type transition is chosen. A certain type of polarization is selected, preferably linear.

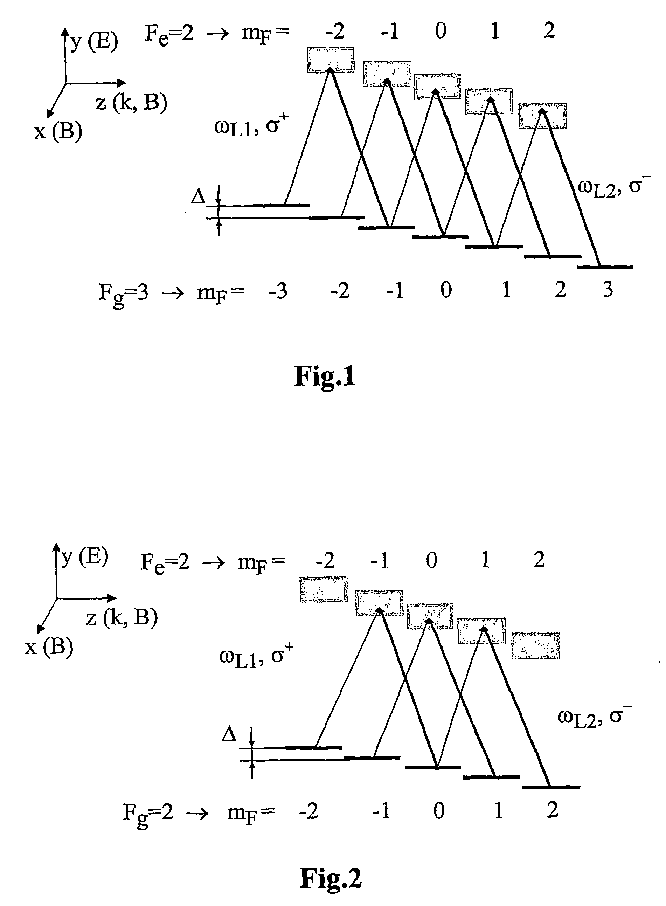

Figure 1 shows a scheme of the possible Zeeman transitions for one hyperfine transition of the I type at the configuration shown in the inset, which illustrates the laser beam propagation direction (k) along the z axis, and the direction of the electric vector (E) of the linearly polarized light along the y or x axis. In this case the incident on the atomic sample laser light can be considered as consisting of two $\sigma^+$ and $\sigma^-$ circularly polarized components. Two electromagnetic fields with frequencies $\omega_{L1}$ and $\omega_{L2}$ and polarization $\sigma^+$ and $\sigma^-$ respectively are also shown. We consider the beam propagation direction (k) along z and the electric vector (E) along y. The unknown magnetic field can have non-zero projections along x, y and/or z. If the magnetic induction of the field B is along x or z, then the incident on the atoms linearly polarized light can be considered as consisting of two circularly polarized components $\sigma^+$ and $\sigma^-$, i.e. exciting transitions between Zeeman sublevels of the basic- and excited-state hyperfine levels with $\Delta m_F = m_{Fe} - m_{Fg} = +1$ or $\Delta m_F = -1$, respectively, as illustrated in Figure 1. If the magnetic induction of the unknown field B is along y, i.e. parallel to the electric vector of the laser field, the light excited $\pi$-transitions, i.e. transitions with $\Delta m_F = 0$.

Continuous adjustment of the modulation frequency $\Omega_M$ is performed, starting from the smallest possible values. Thus, continuous change in the frequency difference between the sidebands in the laser spectrum is accomplished. Each time the two-photon Raman resonance condition is satisfied for a given pair of sidebands and a given pair of basic-state Zeeman sublevels, a resonance is registered in the fluorescence or the transmitted power. When increasing the modulation frequency $\Omega_M$, the last registered resonance is due to excitation with two adjacent-order sidebands in the laser spectrum. A set of non-equidistant resonances is obtained, whose number is determined by the number of sidebands produced in the laser spectrum with enough power to produce observable CPT effect. For clarity, further in the description this finite number of sidebands will be called "number of sidebands in the laser spectrum" and will be denoted by N. A possible way to determine the "last" resonance in the set is to track the frequencies $\Omega_M^n$, at which the resonances appear. The n-th resonance is the last when the ratio $\Omega_M^n = 2\Omega_M^{n-1}$ is reached. The respective modulation frequency will be denoted by $\Omega_M^{max}$. This resonance is obtained by two adjacent-order sidebands in the laser spectrum, inducing $\sigma^+$ and $\sigma^-$ transitions to a common excited-state Zeeman sublevel. Then the relation $2\Delta = \Omega_M^{max}$ is thus reached, giving the value of $\Delta$ - the Zeeman splitting of the basic-state hyperfine level and the magnitude of the magnetic field induction is calculated using the above formula.

It is also possible to determine the ratio $\Omega_M^n / \Omega_M^{n-1}$ between the frequencies at which two adjacent resonances are registered. This ratio gives non-ambiguous determination of the order of the frequency components in the laser spectrum producing these two resonances. The order of the frequency components defines a proportionality coefficient in the Breit-Rabi formula.

The procedure when working with a transition of type II is analogical. The inset in Figure 2 shows the propagation direction of the laser field, its polarization and the direction of the magnetic field. Two electromagnetic fields with frequencies $\omega_{L1}$ and $\omega_{L2}$ and polarizations $\sigma^+$ and $\sigma^-$ respectively are also shown.

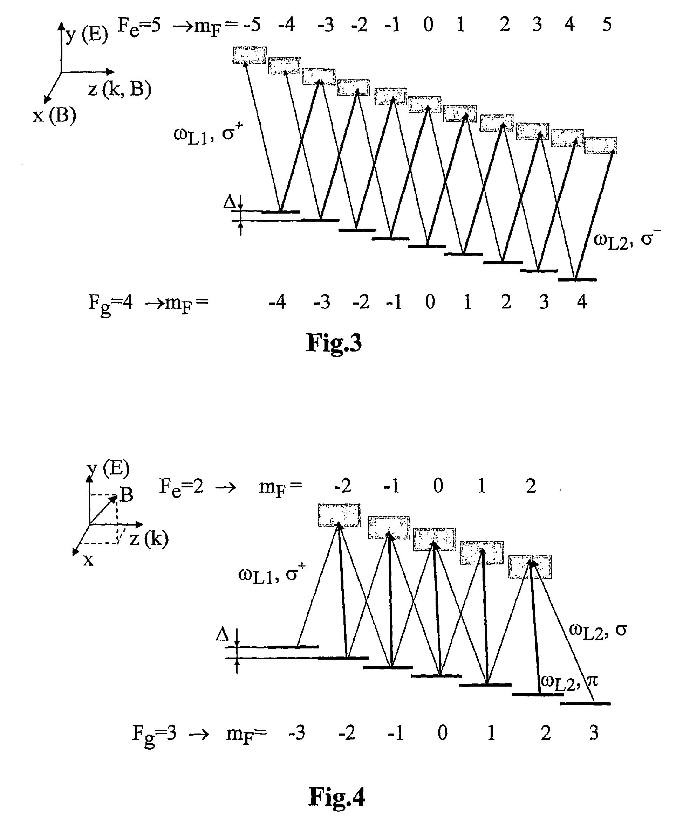

According to another preferred embodiment, transition of type III i s chosen. The calculation procedure is similar and is illustrated in Figure 3. The CR obtained for this kind of transitions are narrower.

If no CR are registered, besides the absence of magnetic field, this could also mean that the magnetic induction of the magnetic field is directed along the y axis, i.e. parallel to the electric vector E of the field. In this case, either the sensor orientation is changed with respect to the z axis, or the polarization direction of the light is turned. If after this no CR are registered, then the magnetic field is zero or smaller than the sensitivity of the method. If CR are registered, the above described measurement procedure is applied.

In the general case, the magnetic field has non-zero projections on all three axes. This case is illustrated in Figure 4 for the case of transitions of type I. Then, Zeeman transitions of $\sigma^+$, $\sigma^-$ and $\pi$ type are created. CR are registered when coupling of $\sigma^+$-$\sigma^-$ transitions with a common excited-state Zeeman sublevel, and also when coupling of $\sigma^+$-$\pi$ and $\sigma^-$-$\pi$ transitions with a common excited-state Zeeman sublevel. The last resonance, though, is again obtained in $\sigma^+$-$\sigma^-$ coupling. Also the adjacent resonance is registered at a modulation frequency two times smaller than that for the last one. Therefore, the above described procedure for measurement of the magnetic field value is also applicable in the general case of arbitrary orientation of the field.

When the magnetic field has non-zero projections only on the x and/or z axis (i.e. $\sigma^+$-$\sigma^-$ transitions are induced), and when increasing the modulation frequency, CR are registered consecutively at frequencies $\Omega_M^n$, where n is from 1 to 2N. Theoretically, they relate as:

described procedure for measurement of the magnetic field value is also applicable in the general case of arbitrary orientation of the field.

When the magnetic field has non-zero projections only on the x and/or z axis (i.e. $\sigma^+$-$\sigma^-$ transitions are induced), and when increasing the modulation frequency, CR are registered consecutively at frequencies $\Omega_M^n$, where n is from 1 to 2N. Theoretically, they relate as:

$$\Omega_M^{(1)} : \Omega_M^{(2)} : \Omega_M^{(3)} : .... : \Omega_M^{(2N-1)} : \Omega_M^{(2N)} = \frac{1}{2N} : \frac{1}{2N-1} : \frac{1}{2N-2} : .... : \frac{1}{2} : 1$$

When the magnetic field has also non-zero projection on the y axis (i.e. $\sigma^-$-$\sigma^-$, $\sigma^+$-$\pi$ and $\sigma^-$-$\pi$ transitions are induced), and when increasing the modulation frequency, CR are registered consecutively at frequencies $\Omega_M^n$, where n is from 1 to 3N, which relate as:

$$\Omega_M^{(1)} : \Omega_M^{(2)} : \Omega_M^{(3)} : .... : \Omega_M^{(N)} : \Omega_M^{(N+1)} : \Omega_M^{(N+2)} : .... : \Omega_M^{(3N-1)} : \Omega_M^{(3N)} =$$
$$= \frac{1}{(2N)\times 2} : \frac{1}{(2N-1)\times 2} : \frac{1}{(2N-2)\times 2} : .... : \frac{1}{(2N-N)\times 2} : \frac{1}{2N-1} : \frac{1}{2N-2} : .... : \frac{1}{2} : 1 \cdot$$

Usually, the first ones are not resolved.

These ratios give the proportionality coefficient in the Breit-Rabi formula. Therefore, if the last resonance is used, the proportionality coefficient is 1 and $1 * \Omega_M^{\max} = 2\Delta$. If two adjacent resonances are used, obtained at modulation frequencies whose ratio is, for example,

$$\Omega_M^i : \Omega_M^{i+1} = \frac{1}{(2n-1)\times 2} : \frac{1}{(2n-2)\times 2},$$

then the relation $(2n-1)*2\Omega_M^i = 2\Delta$ or $(2n-2)*2\Omega_M^{i+1} = 2\Delta$ can be used.

It is also possible to use circularly polarized light, and in this case other kinds of Zeeman transitions are induced, than in the case of linear polarization.

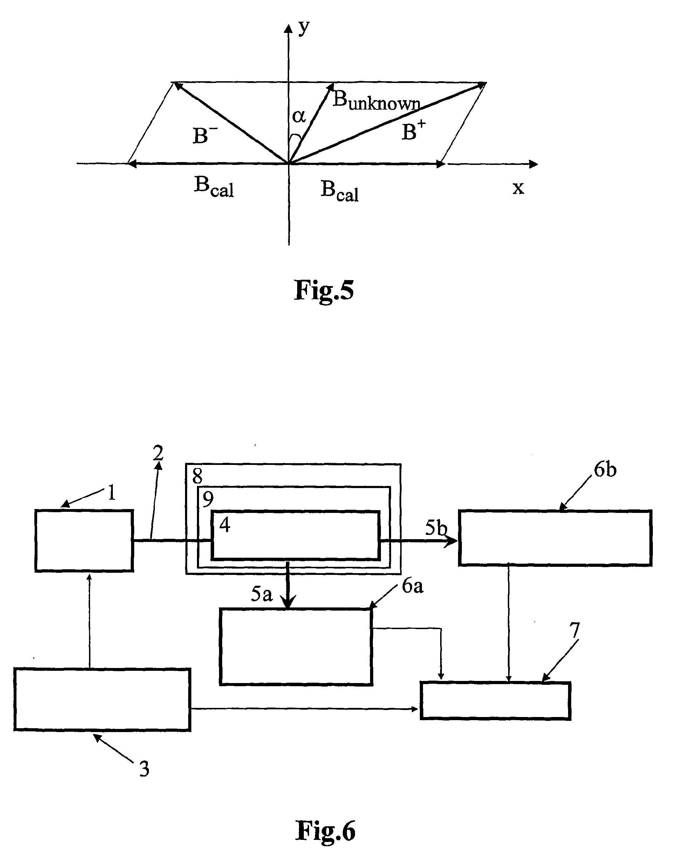

A method is also proposed for measurement of small changes in the magnetic field induction. For this, the alkali atoms sample is put into a system for magnetic field compensation, which is preferably three pairs of Helmholtz coils in three mutually perpendicular directions. The existing big external magnetic field is compensated by means of the current through the coils. Thus, a small change in this magnetic field, which leads to residual non-compensated induction lines, is determined. This determination is accomplished by application of a calibrated constant magnetic field with induction $B_{cal}$ along a certain axis, for example x. As a result, a new field $B^+$ or $B^-$ is created (higher or smaller in absolute magnitude than $B_{cal}$, respectively), depending on the quadrant in which the unknown magnetic field $B_{unknown}$ lies. This is illustrated in Figure 5, where it is also shown that when changing the direction of the induction $B_{cal}$ of the calibrated constant magnetic field (along the same axis) and measuring the magnitude of the resultant field, it is possible to determine the quadrant where the vector of the magnetic induction of the unknown magnetic field $B_{unknown}$ lies. This is the quadrant of the considered plane, where the resultant field has the highest value. As an example, Figure 5 presents the case for the x-y plane, where the resultant field is $B^+$.

This procedure of applying calibrated magnetic field in the two directions of two of the axes x, y and z, makes possible to determine the direction of the vector of the unknown magnetic field, knowing its amplitude. The angle $\alpha$ between this vector and, for example, the y axis, is determined from the following equation:

$$\sin\alpha = \frac{\left(B^{+^2}-B^{-^2}\right)\Big/4B_{cal}}{\sqrt{\left[B^{+^2}-\left(\dfrac{4B_{cal}^2-B^{+^2}-B^{-^2}}{4B_{cal}}\right)\right]+\dfrac{\left(B^{+^2}-B^{-^2}\right)^2}{16B_{cal}^2}}}$$

where $B^+$ and $B^-$ are measured. In the same way the angle between the magnetic induction vector and one of the other two axes z and x can be determined as well.

The preferred embodiment of the device operating on the principle of the described method, is shown in Figure 6. A laser **1** is used, which is preferably a diode laser, with oscillation frequency $\omega_0$. For obtaining sidebands in its spectrum **2,** a modulation system **3** is used. Preferably, the modulation system **3** is a system for direct injection current modulation of the diode laser **1,** with a possibility for continuous adjustment of the modulation frequency $\Omega_M$ up to frequencies in the MHz range. The emission **2** of the laser is fed to a sample of alkali atoms **4,** which is preferably a sealed cell with alkali atoms vapour, for example Cs or Rb, and can be evacuated or with buffer gas added. The fluorescence of the atoms **5a,** or the transmitted through them laser power **5b** is registered. In the first case, a fluorescence registration system **6a** is used, and in the second one - a transmission registration system **6b.** The signal from the registration system **6a** or **6b** is fed to a processor **7** for data processing and visualization.

In some cases it is necessary to measure the magnitude of the magnetic field of a source, which should be isolated from external earth or laboratory magnetic fields. For this reason, the device can also comprise a system for shielding or compensation of external magnetic fields **8.** The system **8** can be a magnetic shield made of high-permittivity metal alloy (for example, $\mu$-metal), or a system of three perpendicular pairs of Helmholtz coils along the x, y and z axes, where external magnetic field compensation in the three directions is accomplished through independent control of the current through each pair of the coils.

When a shielding system is used as the system **8,** the system for application of calibrated magnetic field **9** should be separate. The use of a system of three pairs of Helmholtz coils has two advantages. The first one is that it can be used as a system for application of calibrated magnetic field 9 in the three directions, and the other is that it can be also used as a system for compensation of big magnetic field, thus making possible to measure small changes in this field.

**Claims**

**1.** Method for measurement of the magnetic induction vector of small magnetic fields based on coherent resonances at Zeeman sublevels of a single hyperfine transition in alkali atoms, including the following steps:

(a) creating a frequency modulated laser field with a carrier oscillation frequency $\omega_0$ and modulation frequency $\Omega_M$, so that the spectrum of the laser comprises a carrier frequency $\omega_0$ and sidebands with frequencies $\omega_0 \pm n \Omega_M$, where $\boldsymbol{n}$ is an integer;

(b) putting a sample of alkali atoms under the influence of said magnetic field (Zeeman field) to be measured, removing the Zeeman degeneracy of the atomic levels;

(c) monitoring and registering the power transmitted through the sample or the fluorescence signal of the atom sample;

**characterized in that**

(d) two Zeeman sublevels of a single basic-state hyperfine level are irradiated with a laser field of a chosen polarization, in order to carry out an excitation into a common excited state;

(e) the modulation frequency $\Omega_M$ is in the interval up to several MHz and is continuously adjusted from a minimal value up to the registration for a certain modulation index of a complete set of coherent resonances in the transmitted laser power or the fluorescence signal for determination of the modulation frequency at which the last resonance is registered;

(f) determination of the proportionality coefficient between the modulation frequency at which the respective resonance is registered and the splitting between said two adjacent Zeeman sublevels, and

(g) from the obtained proportionality coefficient and the modulation frequency at which the respective resonance is obtained, calculation of said magnitude of the magnetic induction according to the Breit-Rabi formula.

2. Method for measurement of the magnetic induction vector of small magnetic fields according to claim 1, comprising steps (a), (b), (c), (d), and (g), **characterized in that** the modulation frequency $\Omega_M$ is in the range up to several MHz and is continuously adjusted from a minimal value up to the registration of two arbitrary adjacent resonances in the transmitted laser power or in the fluorescence signal, where the proportionality coefficient between the modulation frequency at which one of these resonances is registered and the splitting between two adjacent Zeeman sublevels is determined from the ratio between the modulation frequencies of these resonances.

3. Method for measurement of the magnetic induction vector of small magnetic fields according to claims 1 or 2, **characterized in that** the laser light is linearly polarized.

4. Method for measurement of the magnetic induction vector of small magnetic fields according to claims 1 or 2, **characterized in that** the laser light is circularly polarized.

5. Method for measurement of the magnetic induction vector of small magnetic fields according to claims 1 to 4, **characterized in that** the Zeeman magnetic field is the measured magnetic field.

6. Method for measurement of the magnetic induction vector of small magnetic fields according to claims 1 to 4, **characterized in that** the Zeeman magnetic field is a residual magnetic field, obtained as a difference between the measured magnetic field and a compensating magnetic field, so that small changes in the value of the magnetic induction of the measured magnetic field are determined.

7. Method for measurement of the magnetic induction vector of small magnetic fields based on coherent resonances at Zeeman sublevels of a single hyperfine transition in alkali atoms according to claims 1 to 4, **characterized in that** the Zeeman magnetic field is a sum magnetic field, obtained as a sum of the measured magnetic field and a calibrated magnetic field applied successively in the two opposite directions of each of three mutually perpendicular axes, where the magnitude and the direction of the measured magnetic field is determined from the magnitude of the projection of the measured magnetic field on each of the axes from the values of the Zeeman magnetic fields obtained when applying the calibrated magnetic field in the two opposite directions of the respective axes.

8. Method for measurement of the magnetic induction vector of small magnetic fields according to claims 1 to 4, **characterized in that** the Zeeman magnetic field is the sum of a calibrated magnetic field, on one hand, and the difference between the measured and compensating magnetic field, on the other, where the calibrated magnetic field is applied successively in the two opposite directions of three mutually perpendicular axes, so that the magnitude and the direction of small changes in the magnetic induction of the measured magnetic field are determined.

9. Device for measurement of the magnetic induction magnitude of small magnetic fields based on coherent resonances at Zeeman sublevels of a single hyperfine transition in alkali atoms according to the method of claims 1 to 5, comprising a laser (**1**) with oscillation frequency $\omega_0$, preferably a diode laser; a system for modulation (**3**) with an

adjustable modulation frequency $\Omega_M$; a sample of alkali atoms (**4**) optically coupled to the laser; a system for registration of the fluorescence signal from the atomic sample (**6a**) or of the transmitted through the sample laser power (**6b**), which is connected to a module for data processing and visualization (**7**), <u>**characterized in that**</u> the adjustable modulation frequency $\Omega_M$ of the modulation system (**3**) is in the interval up to the MHz range.

**10.** Device for measurement of the magnetic induction vector of small magnetic fields according to claim 9, <u>**characterized in that**</u> the sample of alkali atoms (**4**) is situated in a system for application of calibrated magnetic field (**9**).

**11.** Device for measurement of the magnetic induction vector of small magnetic fields based on coherent resonances at Zeeman sublevels of a single hyperfine transition in alkali atoms according to claim 9, <u>**characterized in that**</u> the sample of alkali atoms (**4**) is situated in a system for shielding of external magnetic fields (**8'**).

**12.** Device for measurement of the magnetic induction vector of small magnetic fields based on coherent resonances at Zeeman sublevels of a single hyperfine transition in alkali atoms according to claim 10, <u>**characterized in that**</u> the sample of alkali atoms (**4**) is situated in a system for compensation of external magnetic fields (**8"**).

**13.** Device for measurement of the magnetic induction vector of small magnetic fields according to claim 12, <u>**characterized in that**</u> the system for compensation of external magnetic fields (**8"**) is a system of three mutually perpendicular pairs of Helmholtz coils places along the *x,y* and *z* axes.

**14.** Device for measurement of the magnetic induction vector of small magnetic fields according to claim 13, <u>**characterized in that**</u> the system for compensation of external magnetic field (**8"**), consisting of three mutually perpendicular pairs of Helmholtz coils placed along the x, y and z axes is also a system for application of calibrated magnetic field (**9**).

**15.** Device for measurement of the magnetic induction vector of small magnetic fields based on coherent resonances at Zeeman sublevels of a single hyperfine transition in alkali atoms according to claims 9 to 14, <u>**characterized in that**</u> the sample of alkali atoms (**4**) is a sealed evacuated cell.

**16.** Device for measurement of the magnetic induction vector of small magnetic fields based on coherent resonances at Zeeman sublevels of a single hyperfine transition in alkali atoms according to claims 9 to 14, <u>**characterized in that**</u> the sample of alkali atoms (**4**) is a sealed cell with alkali metal vapour with buffer gas added.

**Patentansprüche**

**1.** Methode zur Messung des Vektors der magnetischen Induktion im Bereich kleiner Magnetfelder auf der Grundlage der kohärenten Resonanzen der Zeeman-Subniveaus eines einzelnen Hyperfeinüberganges von Alkali-Atomen, die folgende Schritte umfassen:

(a) Schaffung einer frequenzmodulierten Laserstrahlung mit einer Trägerfrequenz $\omega_0$ und einer Modulationsfrequenz $\Omega_M$ derart, dass sich das Laserspektrum aus einer Trägerfrequenz $\omega_0$ und den Seitenbändern mit den Frequenzen $\omega_0 \pm n\Omega_M$ zusammensetzt, wobei n eine ganze Zahl darstellt;
(b) Aufhebung der Entartung der Zeemaxi-Subniveaus durch die Einwirkung eines äußeren Magnetfeldes (Zeeman-Feld), erreicht durch die Einbringung einer Alkali-Atom-Probe in ein zu messendes Magnetfeld;
(c) Messung bzw. Registrierung der Fluoreszenzstrahlung oder der transmittierten Strahlung der Alkali-Atom-Probe,
die derart charakterisiert ist, dass:
(d) die (atomare) Population von zwei Zeeman-Subniveaus eines einzelnen Hyperfeinstrukturgrundzustandes mit einem Laserfeld bestimmter Polarisation so angeregt wird, dass ein Übergang/Transfer der Population in einen gemeinsamen, angeregten Zustand stattfindet;
(e) die Modulationsfrequenz im Bereich von bis zu MHz liegt und überdies kontinuierlich von einem Minimalwert bis zu dem Bereich der Registrierung, der aus einem kompletten, vom angegebenen Modulationsindex abhängigen, Satz von Resonanzen besteht, welche sich ihrerseits in der Änderung der Intensität der Fluoreszenzstrahlung oder der Änderung der transmittierten Strahlung äußern;
(f) die Ermittlung des Proportionalitätsfaktors zwischen der Modulationsfrequenz, bei der die jeweilige Resonanz registriert wird und der Aufspaltung zwischen zwei benachbarten Zeeman Subniveaus und
(g) die Berechnung der Größe der magnetischen Induktion nach der Formel von Breit-Rabi gemäß dem erhaltenen Proportionalitätsfaktor und der Modulationsfrequenz, bei der die entsprechende Resonanz nachgewiesen wird.

**2.** Methode zur Messung des Vektors der magnetischen Induktion von kleinen Magnetfeldern gemäß Anspruch 1, der die Schritte (a), (b), (c), (d) und (g) umfasst, die <u>dadurch charakterisiert sind</u>, dass die Modulationsfrequenz im Frequenzbereich bis zu MHz beträgt und überdies kontinuierlich von einem Minimalwert bis zu der Registrierung von zwei ‚willkürlichen, benachbarten Resonanzen, welche sich in einer Änderung der transmittierten Laserleistung oder einer Änderung der Intensität des Fluoreszenzsignals äußern, wobei der Proportionalitätsfaktor zwischen einer dieser registrierten Resonanzen und der Aufspaltung zwischen zwei benachbarten Zeeman-Subniveaus aus dem Verhältnis der Modulationsfrequenzen dieser Resonanzen bestimmt wird.

**3.** Methode zur Messung des Vektors der magnetischen Induktion im Bereich kleiner Magnetfelder gemäß Anspruch 1 und 2, die <u>sich dadurch charakterisiert</u>, dass die Laserstrahlung lineare Polarisation aufweist.

**4.** Methode zur Messung des Vektors der magnetischen Induktion von kleinen Magnetfeldern gemäß Anspruch 1 und 2, die <u>sich dadurch charakterisiert</u>, dass die Laserstrahlung zirkulare Polarisation aufweist.

**5.** Methode zur Messung des Vektors der magnetischen Induktion gemäß den Ansprüchen von 1 bis 4, die <u>sich dadurch charakterisiert</u>, dass das Zeeman Magnetfeld das gemessene Magnetfeld ist.

**6.** Methode zur Messung des Vektors der magnetischen Induktion nach den Ansprüchen 1 bis 4, die <u>sich dadurch charakterisiert</u>, dass das Zeeman Magnetfeld ein Differenzmagnetfeld ist, das als Differenz zwischen dem gemessenen Magnetfeld und dem kompensierenden Magnetfeld ermittelt wird, derart, dass die kleinen Änderungen der Größe der magnetischen Induktion vom gemessenen Magnetfeld bestimmt werden;

**7.** Methode zur Messung des Vektors der magnetischen Induktion im Bereich kleiner Magnetfelder auf der Grundlage der kohärenten Resonanzen der Zeeman-Subniveaus eines einzelnen Hyperfeinüberganges von Alkali-Atomen gemäß den Ansprüchen 1 bis 4, die <u>sich dadurch charakterisiert</u>, dass das Zeeman Magnetfeld ein Summenmagnetfeld ist, das von dem gemessenen Magnetfeld und einem kalibrierten Magnetfeld ermittelt wurde, dass nacheinander in zwei entgegen gesetzten Richtung der drei jeweils senkrecht zueinander stehenden Koordinatenachsen angelegt wird, indem die Größe und die Richtung des gemessenen Magnetfeldes aus den Werten des Magnetfeldes der Projektionen des gemessenen Magnetfeldes auf jede der Koordiantenachsen durch den Vergleich mit den Werte der entsprechenden Zeeman Magnetfeldkomponente eines kalibrierten Magnetfeldes, dass ebenfalls nach oben genannter Prozedur angelegt wird, gewonnen wird.

**8.** Methode zur Messung des Vektors der magnetischen Induktion im Bereich kleiner Magnetfelder gemäß Anspruch 1 bis 4, die <u>sich dadurch charakterisiert</u>, dass sich einerseits das Zeeman Magnetfeld aus der Summe des kalibrierten Magnetfeld und dem zu messenden Magnetfeld zusammensetzt, oder dass sich andererseits das Zeeman Magnetfeld aus der Differenz zwischen dem gemessenen und kompensierenden Magnetfeld derart bildet, dass die Größe und Richtung kleiner Änderungen des Magnetfeldes gemessen werden können, wobei das kalibrierte Magnetfeld nacheinander in den zwei entgegen gesetzten Richtungen der drei jeweils senkrecht zueinander stehenden Koordinatenachsen angelegt wird.

**9.** Vorrichtung zur Messung des Vektors der magnetischen Induktion im Bereich kleiner Magnetfeldern auf der Grundlage der kohärenten Resonanzen der Zeeman-Subniveaus eines einzelnen Hyperfeinüberganges von Alkali-Atomen gemäß den Ansprüchen von 1 bis 5, einschließlich eines Lasers (1) mit Trägerfrequenz $\omega_o$, vorzugsweise ein Diodenlaser; ein Modulationssystem mit durchstimmbarer Modulationsfrequenz $\Omega_M$ (3); eine Alkali-Atom-Probe (4), optisch verbunden mit dem Laser; System zur Registrierung des Fluoreszenzsignals der Alkali-Atom-Probe (6a) und/oder ein System zur Registrierung der transmittierten Laserleistung (6b), die mit dem Block der Signalverarbeitung und -visualisierung verbunden ist (7), enthält, die <u>sich dadurch charakterisiert</u>, dass die durchstimmbare Modulationsfrequenz $\Omega_M$ des Modulationssystems (3) in ihrer Größe bis in den MHz Bereich betragen kann.

**10.** Vorrichtung zur Messung des Vektors der magnetischen Induktion im Bereich kleiner Magnetfelder gemäß Anspruch 9, die <u>sich dadurch charakterisiert</u>, dass die Alkali-Atom-Probe (4) in ein System, geeignet zur Anlegung eines kalibrierten Magnetfeldes (9), eingebettet ist.

**11.** Vorrichtung zur Messung des Vektors der magnetische Induktion im Bereich kleiner Magnetfelder auf der Grundlage der kohärenten Resonanzen der Zeeman-Subniveaus eines einzelnen Hyper-feinüberganges von Alkali-Atomen gemäß Anspruch 9, die <u>sich dadurch charakterisiert</u>, dass die Alkali-Atom-Probe (4) in ein System, geeignet zur Schirmung gegen externe Magnetfeldern (8$^I$), eingebettet ist.

12. Vorrichtung zur Messung des Vektors der magnetische Induktion im Bereich kleiner Magnetfelder auf der Grundlage der kohärenten Resonanzen der Zeeman-Subniveaus eines einzelnen Hyperfein-überganges von Alkali-Atomen gemäß Anspruch 10, die sich dadurch charakterisiert, dass die Alkali-Atom-Probe (4) in ein System, geeignet zur Kompensierung von externen Magnetfeldern (8$^{II}$), eingebettet ist.

13. Vorrichtung zur Messung des Vektors der magnetischen Induktion im Bereich kleiner Magnetfelder gemäß Anspruch 12, die sich dadurch charakterisiert, dass das System für die Kompensierung von externen Magnetfeldern (8$^{II}$) aus einem System von jeweils drei senkrecht zueinander stehenden Paaren von Helmholz Spulen bildet, deren Orientierung entlang der Richtung der x, y und z Achsen eines geeignet gewählten Koordinatensystems weisen.

14. Vorrichtung zur Messung des Vektors der magnetischen Induktion im Bereich kleiner Magnetfelder gemäß Anspruch 13, die sich dadurch charakterisiert, dass das System zur Kompensierung der externen Magnetfeldern (8$^{II}$), bestehend aus einem System von jeweils drei senkrecht zueinander stehenden Paaren von Helmholz Spulen, deren Orientierung entlang der Richtung der x, y und z Achsen eines geeignet gewählten Koordinatensystems weisen, und die zusätzlich für die Erzeugung eines kalibrierten Magnetfeld (9) geeignet sind.

15. Vorrichtung zur Messung des Vektors der magnetischen Induktion im Bereich kleiner Magnetfelder auf der Grundlage der kohärenten Resonanzen der Zeeman-Subniveaus eines einzelnen Hyperfeinüberganges von Alkali-Atomen gemäß den Ansprüchen von 9 bis 14, die sich dadurch charakterisiert, dass die Alkali-Atom-Probe (4) eine evakuierte Zelle (Vakuumzelle) ist.

16. Vorrichtung zur Messung des Vektors der magnetischen Induktion im Bereich kleiner Magnetfelder auf der Grundlage der kohärenten Resonanzen der Zeeman-Subniveaus eines einzelnen Hyperfeinüberganges von Alkali-Atomen gemäß den Ansprüchen von 9 bis 14, die sich dadurch charakterisiert, das die Alkali-Atom-Probe (4) eine abgeschlossene Vakuumzelle ist, in der sich der Alkali-Metall Dampf und zusätzlich ein Puffergas befinden.

**Revendications**

1. Méthode de mesurage du vecteur de l'induction magnétique de petits champs magnétiques basée sur des résonances de cohérence à des sous niveaux de Zeeman d'une transition hyperfine d'atomes alcalins, comprenant les étapes suivantes:

   (a) création d'une radiation laser modulée en fréquence à fréquence de vibration porteuse $\omega_0$ et à fréquence de modulation $\Omega_M$. le spectre du laser comportant une fréquence porteuse centrale $\omega_0$ et des bandes latérales à des fréquences $\omega_0 \pm n\Omega_m$, où $n$ est un nombre entier;
   (b) mettre un échantillon d'atomes alcalins sous l'influence d'un champ magnétique dit (le champ de Zeeman) pour être mesuré, en enlevant la dégénérescence Zeeman des niveaux atomiques;
   (c) contrôle et enregistrement de la puissance ayant traversé l'échantillon ou du signal de fluorescence de l'échantillon d'atome;
   **Se caractérisant par**
   (d) deux sous niveaux de Zeeman du niveau de base hyperfin sont irradiés par un champ laser d'une polarisation déterminée pour réaliser une excitation jusqu'à un niveau général excité;
   (e) la fréquence de modulation $\Omega_M$ englobe un champ d'action jusqu'à des valeurs en MHz et se réajuste d'une manière égale de la valeur minimale à l'enregistrement d'un indice de modulation donné d'un jeu complet de résonances dans la puissance laser ou dans le signal de fluorescence en vue de déterminer la fréquence de modulation à laquelle la dernière résonance est enregistrée;
   (f) la détermination du coefficient de proportionnalité entre la fréquence de modulation à laquelle la résonance respective est enregistrée et la division entre deux sous niveaux de Zeeman adjacents; et
   (g) à partir du coefficient de proportionnalité obtenu et la fréquence de modulation à laquelle la résonance respective est obtenue, le calcul de l'ampleur de l'induction magnétique selon la formule Breit-Rabi.

2. Méthode de mesurage du vecteur de l'induction magnétique de petits champs magnétiques conformément à la prétention 1, comprenant les étapes (a), (b), (c), (d) et (g), **se caractérisant par le fait que**, la fréquence de modulation $\Omega_M$ englobe un champ d'action jusqu'à des valeurs en MHz et se réajuste d'une manière égale d'une valeur minimale jusqu'à l'enregistrement de deux résonances adjacentes arbitraires dans la puissance laser transmise ou dans le signal de fluorescence, où moyennant le rapport entre les fréquences de modulation de ces résonances est déterminé un coefficient de proportionnalité entre la fréquence de modulation à laquelle une de ces résonances est enregistrée et la division entre deux sous niveaux de Zeeman adjacents.

3.  Méthode de mesurage du vecteur de l'induction magnétique de petits champs magnétiques conformément aux prétentions 1 ou 2, **se caractérisant par le fait que**, l'irradiation laser est linéairement polarisée.

4.  Méthode de mesurage du vecteur de l'induction magnétique de petits champs magnétiques conformément aux prétentions 1 ou 2, **se caractérisant par le fait que** l'irradiation laser est circulairement polarisée.

5.  Méthode de mesurage du vecteur de l'induction magnétique de petits champs magnétiques conformément aux prétentions de 1 à 4, **se caractérisant par le fait que** le champ magnétique Zeeman est le champ magnétique mesuré.

6.  Méthode de mesurage du vecteur de l'induction magnétique de petits champs magnétiques conformément aux prétentions de 1 à 4, **se caractérisant par le fait que**, le champ magnétique Zeeman est un champ magnétique résiduel obtenu comme la différence entre le champ magnétique mesuré et le champ magnétique de compensation, où de petits changements de la grandeur de l'induction magnétique du champ magnétique mesuré sont déterminés;

7.  Méthode de mesurage du vecteur de l'induction magnétique de petits champs magnétiques basée sur des résonances de cohérence à des sous niveaux de Zeeman d'une transition hyperfine d'atomes alcalins, conformément à prétentions de 1 à 4, **se caractérisant par le fait que** le champ magnétique Zeeman est un champ magnétique obtenu de la somme du champ magnétique mesuré et du champ magnétique calibré appliqué successivement dans les deux directions de trois axes mutuellement perpendiculaires, la grandeur et la direction du champ magnétique mesuré étant déterminées par la projection du champ magnétique mesuré sur chaque axe par la différence entre les valeurs des champs magnétiques Zeeman obtenues lors de l'application du champ magnétique calibré dans les deux directions opposées de l'axe respectif.

8.  Méthode de mesurage du vecteur de l'induction magnétique de petits champs magnétiques conformément aux prétentions de 1 à 4, **se caractérisant par le fait que** le champ magnétique Zeeman représente la somme d'un champ magnétique calibré, d'une part, et de la différence entre le champ magnétique mesuré et le champ magnétique de compensation d'autre part, le champ magnétique calibré étant successivement appliqué dans les deux directions de trois axes mutuellement perpendiculaires, en déterminant ainsi la grandeur et la direction d'un petit changement de l'induction magnétique du champ magnétique mesuré.

9.  Dispositif de mesurage du vecteur de l'induction magnétique de petits champs magnétiques basé sur des résonances de cohérence à des sous niveaux de Zeeman d'une transition hyperfine d'atomes alcalins, conformément à prétentions de 1 à 5, comprenant un laser (1) d'une fréquence de vibration $\omega_o$, de préférence un laser-diode; un système de modulation à fréquence de modulation $\Omega_M$ réglable (3); échantillon d'atomes alcalins (4), couplé au laser par voie optique; système d'enregistrement d'un signal de fluorescence de l'échantillon d'atomes (6a) ou de la puissance laser transmise à travers l'échantillon (6b), qui est connecté à un module de traitement des signaux et de visualisation (7), **se caractérisant par le fait que**, la grandeur de la fréquence de modulation réglable $\Omega_M$ du système de modulation (3) englobe un champ d'action jusqu'à des valeurs en MHz.

10. Dispositif de mesurage du vecteur de l'induction magnétique de petits champs magnétiques conformément à la prétention 9, **se caractérisant par le fait que**, l'échantillons d'atomes alcalins (4) est disposé dans un système d'application d'un champ magnétique calibré (9).

11. Dispositif de mesurage du vecteur de l'induction magnétique de petits champs magnétiques basé sur des résonances de cohérence à des sous niveaux de Zeeman d'une transition hyperfine d'atomes alcalins, conformément à la prétention 9, **se caractérisant par le fait que** l'échantillon d'atomes alcalins (4) est disposé dans un système de blindage contre des champs magnétiques extérieurs ($8^I$).

12. Dispositif de mesurage du vecteur de l'induction magnétique de petits champs magnétiques basé sur des résonances de cohérence à des sous niveaux de Zeeman d'une transition hyperfine d'atomes alcalins, conformément à la prétention 10, **se caractérisant par le fait que** l'échantillon d'atomes alcalins (4) est disposé dans un système de compensation de champs magnétiques extérieurs ($8^{II}$).

**13.** Dispositif de mesurage du vecteur de l'induction magnétique de petits champs magnétiques conformément à la prétention 12, **se caractérisant par le fait que**, le système de compensation de champs magnétiques extérieurs (8$^{II}$) représente un système de trois paires de bobines de Helmholtz mutuellement perpendiculaires, placées sur les axes **x, y** et **z**.

**14.** Dispositif de mesurage du vecteur de l'induction magnétique de petits champs magnétiques conformément à la prétention 13, **se caractérisant par le fait que**, le système de compensation de champs magnétiques extérieurs (8$^{II}$) composé de trois paires de bobines de Helmholtz mutuellement perpendiculaires, placées sur les axes **x, y** et **z**, représente aussi un système d'application d'un champ magnétique calibré (9).

**15.** Dispositif de mesurage du vecteur de l'induction magnétique de petits champs magnétiques basé sur des résonances de cohérence à des sous niveaux de Zeeman d'une transition hyperfine d'atomes alcalins, conformément aux prétentions de 9 à 14, **se caractérisant par le fait que** l'échantillon d'atomes alcalins (4) est une cellule scellée évacuée.

**16.** Dispositif de mesurage du vecteur de l'induction magnétique de petits champs magnétiques basé sur des résonances de cohérence à des sous niveaux de Zeeman d'une transition hyperfine d'atomes alcalins, conformément aux prétentions de 9 à 14, **se caractérisant par le fait que** l'échantillon d'atomes alcalins (4) est une cellule scellée par des vapeurs d'un métal alcalin avec du gaz protecteur.

**Fig.1**

**Fig.2**

Fig.3

Fig.4

**Fig.5**

**Fig.6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M. STÄHLER ; S. KNAPPE ; C. AFFOLDERBACH ; W. KEMP ; R. WYNANDS.** Picotesla magnetometry with coherent dark states. *Europhysics Letters,* 2001, vol. 54 (3), 323-328

- **HOLLBERG ; KNAPPE ; STAHLER.** Miniaturized laser magnetometers and clocks. *ICONO 2001: Quantum and Atomic Optics, HighPrecision Measurements in Optics, and Optical Information Processing Proc. SPIE,* 2001, vol. 4750, 126